Europäisches Patentamt

European Patent Office

Office européen des brevets

(11) Publication number: **0 204 576**
**A2**

## (12) EUROPEAN PATENT APPLICATION

(21) Application number: **86304305.5**

(22) Date of filing: **05.06.86**

(51) Int. Cl.⁴: **H 03 M 13/00**
**//G06F11/10**

(30) Priority: **07.06.85 JP 123756/85**

(43) Date of publication of application:
**10.12.86 Bulletin 86/50**

(84) Designated Contracting States:
**DE FR GB NL**

(71) Applicant: **SONY CORPORATION**
**7-35 Kitashinagawa 6-Chome Shinagawa-ku Tokyo 141(JP)**

(72) Inventor: **Kojima, Yuichi c/o Patents Division Sony Corporation 6-7-35 Kitashinagawa Shinagawa-ku Tokyo 141(JP)**

(74) Representative: **Pilch, Adam John Michael et al, c/o D. Young & Co. 10 Staple Inn London WC1V 7RD(GB)**

(54) **Apparatus for and methods of decoding a BCH code.**

(57) Apparatus for decoding a Bose-Chaudhuri-Hocquenghem (BCH) code can correct double errors, using a modification of the Chien search method. The decoding apparatus comprises circuits (2, 3) for forming syndromes S1 and S3, a circuit (5) for forming $S1^2$, a circuit (6) for forming $S1^3$, a circuit (7) for forming ($S1^3$ + S3), and a Chien search circuit (8) in which the error-location polynomial $\sigma'(x) = S1x^2 + S1^2 x + S1^3 + S3$ is solved, thereby enabling correction of errors of two or less. With this apparatus, there is no need to perform a dividing process, and a high decoding processing speed can be realised without using either a PLA or a ROM.

*Fig. 1*

EP 0 204 576 A2

1

# APPARATUS FOR AND METHODS OF DECODING A BCH CODE

This invention relates to apparatus for and methods of decoding a Bose-Chaudhuri-Hocquenghem (BCH) code, and in particular to such apparatus and methods capable of correcting double errors.

A method of decoding a BCH code which can correct double errors has been previously proposed whereby two syndromes $S1$ and $S3$ are formed from a received code sequence and then the error-location polynomial

$$\sigma(x) = x^2 + S1\, x + S1^2 + (S3/S1)$$

is solved by a method called the Chien search method, thereby correcting the errors in the received sequence.

In this decoding process, the calculation of the syndromes $S1$ and $S3$ and the calculation of $S1^2$ can be relatively easily realised by a hard-wired logic arrangement such as a gate array or the like. However, the dividing process of $S3/S1$ is more complicated. Therefore, the dividing process has been performed using a read only memory (ROM) which limits the speed of operation which can be obtained.

When the decoding apparatus is in the form of a large scale integrated (LSI) circuit chip, with the dividing circuit constituted by a programmable logic array (PLA), the scale of the LSI chip has to be enlarged, which is a drawback. On the other hand, when the dividing circuit is constituted by a ROM, the decoding processing time is restricted by the access time, resulting in the drawback that the decoding process cannot be executed at a high speed.

According to the present invention there is provided apparatus for decoding a Bose-Chaudhuri-Hocquenghem (BCH) code, the apparatus comprising:

first and second circuits for respectively forming syndromes $S1$ and $S3$ from a received code sequence;

a third circuit connected to said first circuit to form the value $S1^2$ from the syndrome $S1$;

a fourth circuit connected to said first circuit to form the value $S1^3$ from the syndrome $S1$;

a fifth circuit connected to said first and second circuits to form the value $(S1^3 + S3)$; and

a Chien search circuit connected to said first, third and fifth circuits to receive said values $S1$, $S1^2$ and $(S1^3 + S3)$, and to solve the error-location polynomial

$$\sigma'(x) = S1 \; x^2 + S1^2 \; x + \; S1^3 + S3$$

thereby being capable of correcting errors of two or less in said received sequence.

According to the present invention there is also provided a method of decoding a Bose-Chaudhuri-Hocquenghem (BCH) code, the method comprising the steps of:

forming syndromes $S1$ and $S3$ from a received code sequence;

processing and combining said syndromes to form the value $(S1^3 + S3)$;

using a Chien search circuit to produce an output signal corresponding to $\sigma'(x) = S1 \; x^2 + S1^2 \; x + S1^3 + S3$; and

inverting bits in said received sequence in accordance with said output signal, thereby correcting errors in said received sequence.

According to the present invention there is further provided a decoding apparatus for a Bose-Chaudhuri-Hocquenghem (BCH) code capable of correcting double errors by use of the Chien search method, the apparatus comprising:

circuits to form syndromes $S1$ and $S3$;

a circuit to form $S1^2$;

a circuit to form $S1^3$;

a circuit to form $(S1^3$ and $S3)$; and

a Chien search circuit,

wherein the error-location polynomial $\sigma'(x) = S1 \; x^2 + S1^2 \; x + S1^3 + S3$ is solved, thereby correcting errors of two or less.

A preferred embodiment of the present invention provides an apparatus for decoding a BCH code which is suitable for LSI realisation, without using either a ROM or a PLA.

By using the polynomial $\sigma'(x) = S1 \; x^2 + S1^2 \; x + S1^3 + S3$ as the error-location polynomial, the term for the dividing process $S3/S1$ is removed from the error-location polynomial, and the error-location polynomial can be solved without a dividing process, thereby obtaining the error locations and correcting the errors. Since there is no need to perform the dividing process $S3/S1$, the decoding apparatus can have a simple constitution and a high decoding processing speed can be realised without using a PLA or a ROM.

The invention will now be described by way of example with reference to the accompanying drawings, in which:

Figure 1 is a functional block diagram of an illustrative embodiment of the present invention;

Figure 2 is a block diagram of a circuit for forming the syndrome $S1$;

Figure 3 is a block diagram of a circuit for forming the syndrome $S3$;

Figure 4 is a block diagram of a circuit for forming the term $S1^2$;

Figure 5 is a block diagram of a circuit for forming the term $S1^3$;

Figure 6 is a block diagram of a circuit for forming the term $(S1^3 + S3)$;

Figure 7 is a block diagram of a circuit for multiplying by $\alpha^{-2}$; and

Figure 8 is a block diagram of a circuit for multiplying by $\alpha^{-1}$.

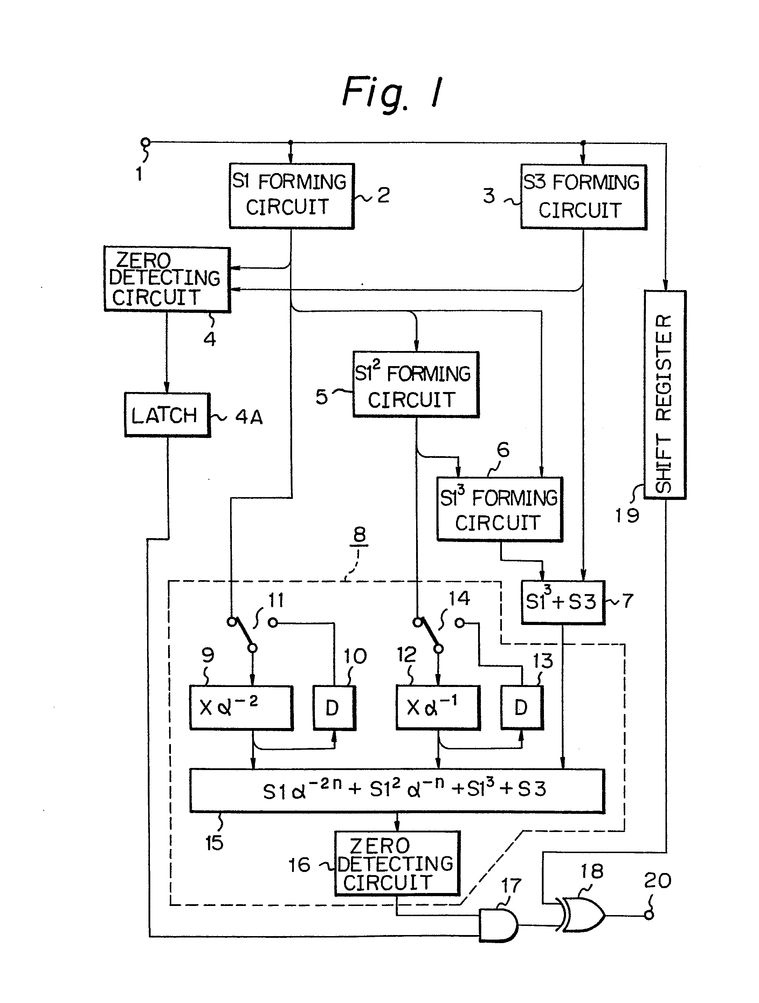

Referring to Figure 1, a received code sequence to be decoded is applied to an input terminal 1. The received sequence is supplied to an $S1$ forming circuit 2 and an $S3$ forming circuit 3 in which the syndromes $S1$ and $S3$ are respectively formed. The syndromes $S1$ and $S3$ are supplied to a zero detecting circuit 4. The zero detecting circuit 4 generates a detection signal of a low level "L" when all of the digits of the syndromes $S1$ and $S3$ are "0", namely, when no error is detected. This detection signal is supplied to a latch circuit 4A synchronously with the receiving sequence.

The syndrome $S1$ is supplied to an $S1^2$ forming circuit 5 and an $S1^3$ forming circuit 6 and the values of $S1^2$ and $S1^3$ are produced. The $S1^3$ forming circuit 6 multiplies $S1^2$ by $S1$ to produce $S1^3$ as will be explained hereinafter. The syndromes $S3$ and $S1^3$ are supplied to an arithmetic operating circuit 7, in which the value $(S1^3 + S3)$ is formed.

In this manner, the respective coefficients $S1$, $S1^2$, $S1^3$, and $S3$ of the error-location polynomial $\sigma'(x)$ are obtained and supplied to a Chien search circuit 8 for performing the process of the Chien search. The Chien search circuit 8 is shown as the region surrounded by the broken line in Figure 1 and comprises arithemtic operating circuits 9 and 12, delay circuits 10 and 13 each having a delay time of one clock pulse, switching circuits 11 and 14, an adding circuit 15 and a zero detecting circuit 16. The switching circuits 11 and 14 respectively select the syndrome S1 from the S1 forming circuit 2 and $S1^2$ from the $S1^2$ forming circuit 5 at the time of the head bit in the received sequence. The switching circuits 11 and 14 respectively select outputs of the delay circuits 10 and 13 with respect to the remaining bits in the received sequence. Control of the switching circuits 11 and 14 is accomplished by a conventional circuit for generating timing control signals, operating in synchronism with the received sequence.

Outputs of the switching circuits 11 and 14 are supplied to the arithmetic operating circuits 9 and 12, respectively. Outputs of the operating circuits 9 and 12 are supplied to the delay circuits 10 and 13, respectively. In this way, a cyclic constitution is obtained. The operating circuit 9 multiplies its input by $\alpha^{-2}$ and the operating circuit 12 multiplies its input by $\alpha^{-1}$. $\alpha$ is the root of the generator polynomial over the Galois Field GF ($2^m$). Assuming that a code length is n, the term $S1 \, \alpha^{-2n}$ is obtained by the operating circuit 9 and the term $S1^2 \alpha^{-n}$ is derived by the operating circuit 12. The outputs of the operating circuits 9 and 12 are supplied to the adding circuit 15 to perform modulo-2 (mod 2) addition.

The adding circuit 15 executes the arithmetic operation of the error-location polynomial $\sigma'(x) = S1 \, x^2 + S1^2 \, x + S1^3 + S3$. An output of the adding circuit 15 is supplied to the zero detecting circuit 16. The position at which the output of the adding circuit 15 becomes zero is the error location. The zero detecting circuit 16 generates a correction instructing signal in the form of a high level "H" signal at the error location.

The correction instructing signal from the zero detecting circuit 16 is supplied to an AND gate 17 together with an output of the latch circuit 4A. The output of the latch circuit 4A becomes a low level "L" signal, due to the zero detecting circuit 4, when all digits of both of the syndromes S1 and S3 are "0". When S1 = S3 = 0, the result of the operation of the error-location polynomial becomes zero, so that the correction instructing signal which signals an error is generated from the zero detecting circuit 16. The AND gate 17 is provided to inhibit an improper correction instructing signal.

The correction instructing high level "H" signal from the AND gate 17 is supplied to an exclusive OR gate (hereinafter referred to as EX-OR gate) 18. The bits of the received sequence supplied via a shift register 19 are inverted by the EX-OR gate 18 in response to the correction instructing signal which is generated in correspondence to the error location, so that the bit errors are corrected. The error-corrected data sequence from the EX-OR gate 18 is taken out to an output terminal 20. The shift register 19 delays the received sequence by the period of time necessary for detection of the error location.

The circuit can be applied to decode, for example, a (15, 7) BCH code, in which (15) denotes the code length and (7) is the information bit length and the minimum distance is 5. Therefore, any errors of two bits or less can be corrected. The generator polynomial of this case is

$$G(x) = (x^4 + x + 1)(x^4 + x^3 + x^2 + x + 1)$$
$$= x^8 + x^7 + x^6 + x^4 + 1 .$$

Assuming that $\alpha$ is the root of $(x^4 + x + 1) = 0$, the minimal polynomial having $\alpha^3$ as the root is $(x^4 + x^3 + x^2 + x + 1)$. The elements over the Galois Field $GF(2^4)$ which is given by $(x^4 + x + 1) = 0$ are as follows:

| | $\alpha^3$ | $\alpha^2$ | $\alpha^1$ | $\alpha^0$ |
|---|---|---|---|---|
| 0 | 0 | 0 | 0 | 0 |
| $\alpha^0$ | 0 | 0 | 0 | 1 |
| $\alpha^1$ | 0 | 0 | 1 | 0 |
| $\alpha^2$ | 0 | 1 | 0 | 0 |
| $\alpha^3$ | 1 | 0 | 0 | 0 |
| $\alpha^4$ | 0 | 0 | 1 | 1 |
| $\alpha^5$ | 0 | 1 | 1 | 0 |
| $\alpha^6$ | 1 | 1 | 0 | 0 |
| $\alpha^7$ | 1 | 0 | 1 | 1 |
| $\alpha^8$ | 0 | 1 | 0 | 1 |
| $\alpha^9$ | 1 | 0 | 1 | 0 |
| $\alpha^{10}$ | 0 | 1 | 1 | 1 |
| $\alpha^{11}$ | 1 | 1 | 1 | 0 |
| $\alpha^{12}$ | 1 | 1 | 1 | 1 |
| $\alpha^{13}$ | 1 | 1 | 0 | 1 |
| $\alpha^{14}$ | 1 | 0 | 0 | 1 |

The parity-check matrix H of this code is shown below.

$$H = \begin{pmatrix} \alpha^0 & \alpha^1 & \alpha^2 & \alpha^3 & \alpha^4 & \alpha^5 & \alpha^6 & \alpha^7 & \alpha^8 & \alpha^9 & \alpha^{10} & \alpha^{11} & \alpha^{12} & \alpha^{13} & \alpha^{14} \\ \alpha^0 & \alpha^3 & \alpha^6 & \alpha^9 & \alpha^{12} & \alpha^0 & \alpha^3 & \alpha^6 & \alpha^9 & \alpha^{12} & \alpha^0 & \alpha^3 & \alpha^6 & \alpha^9 & \alpha^{12} \end{pmatrix}$$

$$= \begin{pmatrix} 1 & 0 & 0 & 0 & 1 & 0 & 0 & 1 & 1 & 0 & 1 & 0 & 1 & 1 & 1 \\ 0 & 1 & 0 & 0 & 1 & 1 & 0 & 1 & 0 & 1 & 1 & 1 & 1 & 0 & 0 \\ 0 & 0 & 1 & 0 & 0 & 1 & 1 & 0 & 1 & 0 & 1 & 1 & 1 & 1 & 0 \\ 0 & 0 & 0 & 1 & 0 & 0 & 1 & 1 & 0 & 1 & 0 & 1 & 1 & 1 & 1 \\ 1 & 0 & 0 & 0 & 1 & 1 & 0 & 0 & 0 & 1 & 1 & 0 & 0 & 0 & 1 \\ 0 & 0 & 0 & 1 & 1 & 0 & 0 & 0 & 1 & 1 & 0 & 0 & 0 & 1 & 1 \\ 0 & 0 & 1 & 0 & 1 & 0 & 0 & 1 & 0 & 1 & 0 & 0 & 1 & 0 & 1 \\ 0 & 1 & 1 & 1 & 1 & 0 & 1 & 1 & 1 & 1 & 0 & 1 & 1 & 1 & 1 \end{pmatrix}$$

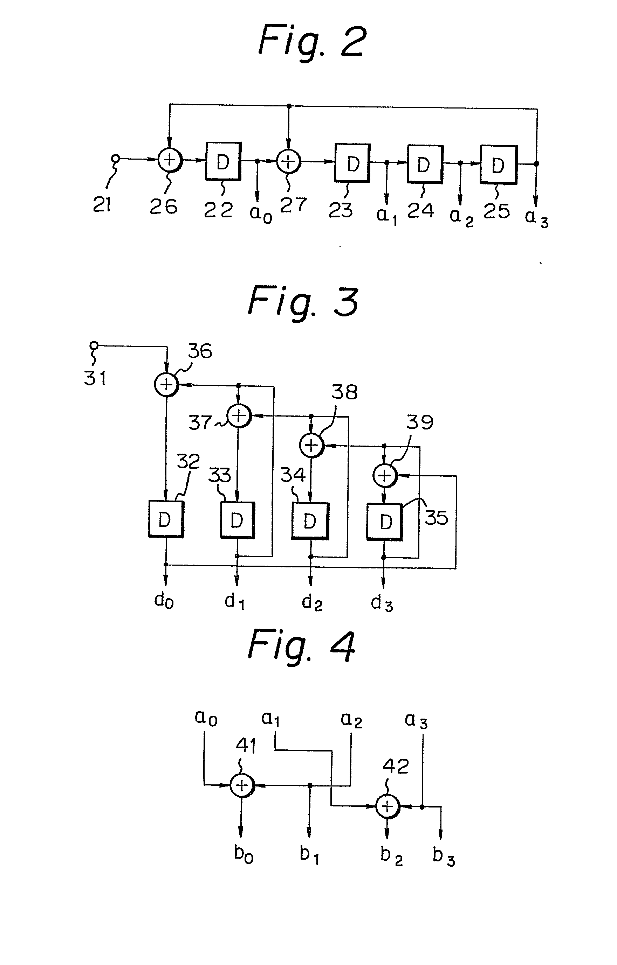

Figure 2 shows an example of the S1 forming circuit 2 for forming the syndrome S1. The syndrome can be obtained by calculating $\gamma(\alpha^j)$ with respect to the received code word

$$\gamma(x) = \gamma_0 + \gamma_1 x + \ldots\ldots + \gamma_{14} x^{14}.$$

The S1 forming circuit 2 calculated for $j = 1$, namely, $\gamma(\alpha)$. As shown in Figure 2, flip-flops 22, 23, 24 and 15 each having a delay time of one clock pulse are cascade-connected with respect to the received sequence. In the case of the polynomial $(x^4 + x + 1)$, an adding circuit 26 is inserted between the input terminal 21 and the flip-flop 22. The adding circuit 26 performs mod 2 addition and may be realised by an EX-OR gate. All of the following adding circuits are similarly mod 2 adding circuits.

The mod 2 additions are as follows:

$0 \oplus 0 = 0$

$0 \oplus 1 = 1$

$1 \oplus 0 = 1$

$1 \oplus 1 = 0$

An adding circuit 27 is also provided between the flip-flops 22 and 23. An output of the flip-flop 25 is fed back to both adding circuits 26 and 27.

When a "1" signal is provided to the input terminal 21 and the shift registers consisting of the flip-flops 22 to 25 are sequentially shifted, the binary expressions of $\alpha^0$, $\alpha^1$, ---, $\alpha^{14}$ are provided as outputs from the respective flip-flops. Therefore, by sequentially providing the received sequence $\gamma^{14}$, $\gamma^{13}$, ---, $\gamma^0$ to the input terminal 21, the syndrome S1 (a0, a1, a2, a3) is obtained.

Figure 3 shows an example of the S3 forming circuit 3 for forming the syndrome S3. The S3 forming circuit 3 calculates for j = 3, namely, $\gamma(\alpha^3)$. Four flip-flops 32, 33, 34 and 35 are provided. Adding circuits 36, 37, 38 and 39 are also provided on the input sides of the flip flops 32 to 25, respectively. The received sequence from an input terminal 31 and an output of the flip-flop 33 are supplied to the adding circuit 36. Outputs of the flip-flops 33 and 34 are supplied to the adding circuit 37. Outputs of the flip-flops 34 and 35 are supplied to the adding circuit 38. Outputs of the flip-flops 35 and 32 are supplied to the adding circuit 39.

By sequentially supplying the received sequence $\gamma^{14}$, $\gamma^{13}$, ---, $\gamma^0$ to the input terminal 31, the syndrome S3, (d0, d1, d2, d3) is obtained.

Figure 4 shows an example of the $S1^2$ forming circuit 5 for forming the square of the syndrome S1 (a0, a1, a2, a3). The $S1^2$ forming circuit 5 comprises an adding circuit 41 which is supplied with a0 and a2 and an adding circuit 42 which is supplied with a1 and a3. Assuming that $S1^2$ is (b0, b1, b2, b3) then b0 is the output from the adding circuit 41, and a2 is connected to the output as b1; b2 is connected to the output from the adding circuit 42 and a3 is connected to the output as b3.

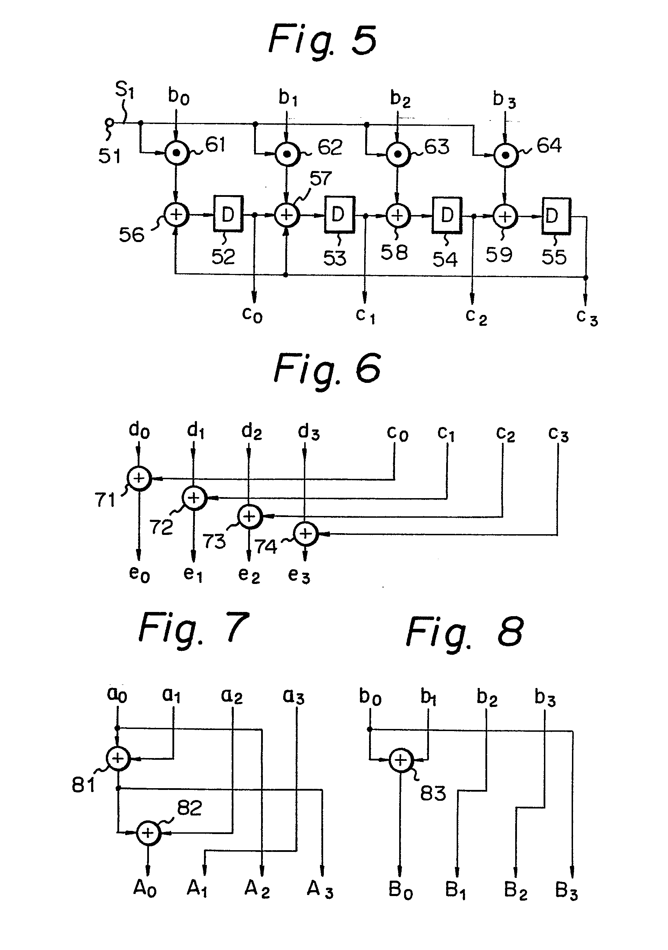

Figure 5 shows an example of the $S1^3$ forming circuit 6. The syndrome S1 (a0, a1, a2, a3) produced by the S1 forming circuit 2 is supplied to an input terminal 51. Adding circuits 56, 57, 58 and 59 are provided on the input sides of four flip-flops 52, 53, 54 and 55 which are respectively cascade-connected. An output of the flip-flop 55 is fed back as one input of each of the adding circuits 56 to 59. Outputs of multiplying circuits 61, 62, 63 and 64 for executing mod 2 multiplications are supplied as the other inputs of the adding circuits 56 and 57, respectively.

The mod 2 multiplications are as follows:

$$0 \cdot 0 = 0$$
$$0 \cdot 1 = 0$$
$$1 \cdot 0 = 0$$
$$1 \cdot 1 = 1$$

The syndrome S1 from the input terminal 51 is supplied to one input of each of the multiplying circuits 61 to 64, and $S1^2$ (b0, b1, b2, b3) is supplied to the other inputs of the multiplying circuits 61 to 64, respectively. $S1^3$ (c0, c1, c2, c3) is generated as outputs of the flip-flops 52 to 55, respectively. Namely, the $S1^3$ forming circuit 6 of Figure 5 multiplies $S1^2$ by S1.

An explanation is given hereinbelow as to the product C of two elements A and B over the Galois Field, which can be derived by the $S1^3$ forming circuit 6 of Figure 5.

Firstly, it is assumed that the elements A and B are expressed by the following polynomial expressions:

$$A = a3 \, \alpha^3 + a2 \, \alpha^2 + a1 \, \alpha + a0$$
$$B = b3 \, \alpha^3 + b2 \, \alpha^2 + b1 \, \alpha + b0.$$

The product C of the elements A and B is as shown below.

$$
\begin{aligned}
C &= A \times B \\
&= (a3 \, \alpha^3 + a2 \, \alpha^2 + a1\alpha + a0) \times \\
&\quad (b3 \, \alpha^3 + b2 \, \alpha^2 + b1\alpha + b0) \\
&= (a3 \, b3 \, \alpha^3 + a2 \, b3 \, \alpha^2 + a1 \, b3\alpha + a0 \, b3) \, \alpha^3 + \\
&\quad (a3 \, b2 \, \alpha^3 + a2 \, b2 \, \alpha^2 + a1 \, b2\alpha + a0 \, b2) \, \alpha^2 + \\
&\quad (a3 \, b1 \, \alpha^3 + a2 \, b1 \, \alpha^2 + a1 \, b1\alpha + a0 \, b1) \, \alpha + \\
&\quad a3 \, b0 \, \alpha^3 + a2 \, b0 \, \alpha^2 + a1 \, b0\alpha + a0 \, b0 \\
&= c3 \, \alpha^3 + c2 \, \alpha^2 + c1 \, \alpha + c0 \quad .
\end{aligned}
$$

The flip-flops 52 to 55 are sequentially shifted for every clock pulse from the initial state. The output C''' becomes

$$C''' = c3$$

at the first shift. The output C'' becomes

$$C'' = c3 \, \alpha + c2$$

at the second shift. The output C' becomes

$$C' = (c3\ \alpha + c2)\alpha + c1$$
$$= c3\ \alpha^2 + c2\ \alpha + c1$$

at the third shift. The output C becomes

$$C = (c3\ \alpha^2 + c2\ \alpha + c1)\ \alpha + c0$$
$$= c3\ \alpha^3 + c2\ \alpha^2 + c1\ \alpha + c0$$

at the fourth shift. In this manner, the multiplications are completed.

The case where $A = \alpha^3$ and $B = \alpha^6$ will be described as a practical example. These values are represented by the following binary expressions.

$$(a3, a2, a1, a0) = (1\ 0\ 0\ 0)$$
$$(b3, b2, b1, b0) = (1\ 1\ 0\ 0)$$

When the shifting operations are sequentially performed from the initial state, the outputs (c3, c2, c1, c0) change as shown in the following table.

|  | Input | c3 | c2 | c1 | c0 |
|---|---|---|---|---|---|
| Initial state | 1 | 0 | 0 | 0 | 0 |
| First shift | 1 | 1 | 0 | 0 | 0 |
| Second shift | 0 | 1 | 0 | 1 | 1 |
| Third shift | 0 | 0 | 1 | 0 | 1 |
| Fourth shift | – | 1 | 0 | 1 | 0 |

As will be understood from this table, the multiplication output of ( $\alpha^3 \times \alpha^6 = \alpha^9 = 1\ 0\ 1\ 0$) can be obtained by performing the shifting operation four times.

As opposed to the case where $S1^3$ is directly obtained from the syndrome $S1$, the $S1^3$ forming circuit 6 in this embodiment derives $S1^3$ by multiplying $S1$ and $S1^2$ together. Consequently, the circuit construction can be considerably simplified.

As shown in Figure 6, in the arithmetic operating circuit 7 which obtains ($S1^3 + S3$), the corresponding bits of S3 (= c0, c1, c2, c3) and $S1^3$ (= d0, d1, d2, d3) are respectively supplied to adding circuits 71, 72, 73 and 74. The binary expressions (e0, e1, e2, e3) of $(S1^3 + S3)$ are derived from the adding circuits 71 to 74.

The arithmetic operating circuit 9 for multiplying the syndrome S1 (a3, a2, a1, a0) by $\alpha^{-2}$ comprises adding circuits 81 and 82 as shown in Figure 7; a0 and a1 are supplied to the adding circuit 81. An output of the adding circuit 81 and a2 is supplied to the adding circuit 82. The output of the adding circuit 82 is A0, the input a3 is A1, the input a0 is A2, and the output of the adding circuit 81 is A3. Namely,

$$\alpha^{-2} (a0 + a1\alpha + a2\,\alpha^2 + a3\,\alpha^3)$$
$$= a0\,\alpha^{-2} + a1\,\alpha^{-1} + a2 + a3\alpha$$
$$= a0\,(\alpha^3 + \alpha^2 + 1) + a1\,(\alpha^3 + 1) + a2 + a3\alpha$$
$$= (a0 + a1 + a2) + a3\alpha + a0\,\alpha^2 + (a0 + a1)\,\alpha^3$$
$$= A0 + A1\alpha + A2\,\alpha^2 + A3\,\alpha^3 .$$

The arithmetic operating circuit 12 for multiplying $S1^2$ (b3, b2, b1, b0) by $\alpha^{-1}$ comprises an adding circuit 83 as shown in Figure 8; b0 and b1 are supplied to the adding circuit 83. An output of the adding circuit 83 is B0, the input b2 is B1, the input b3 is B2, and the input b0 is B3. Namely,

$$\alpha^{-1} (b0 + b1\alpha + b2\,\alpha^2 + b3\alpha^3)$$
$$= b0\,(\alpha^3 + 1) + b1 + b2\,\alpha + b3\,\alpha^2$$
$$= (b0 + b1) + b2\alpha + b3\,\alpha^2 + b0\,\alpha^3$$
$$= B0 + B1\alpha + B2\,\alpha^2 + B3\alpha^3 .$$

Since there is no need to calculate the division term S3/S1 in the error-location polynomial $\sigma'(x)$, it is unnecessary to use any dividing circuit embodied in complicated hard-wired logic, or any dividing circuit using a ROM, which would restrict the decoding processing speed of the whole decoding apparatus. Consequently, it is possible to realise a decoding apparatus having a simple constitution and a hard-wired logic arrangement such as a gate array or the like, which is suitable for production in the form of an LSI.

**0204576**

CLAIMS

1.  Apparatus for decoding a Bose-Chaudhuri-Hocquenghem (BCH) code, the apparatus comprising:

first and second circuits (2,3) for respectively forming syndromes S1 and S3 from a received code sequence;

a third circuit (5) connected to said first circuit (2) to form the value $S1^2$ from the syndrome S1;

a fourth circuit (6) connected to said first circuit (2) to form the value $S1^3$ from the syndrome S1;

a fifth circuit (7) connected to said first and second circuits (2,3) to form the value $(S1^3 + S3)$; and

a Chien search circuit (8) connected to said first, third and fifth circuits (2,5,7) to receive said values S1, $S1^2$ and $(S1^3 + S3)$, and to solve the error-location polynomial

$$\sigma'(x) = S1 \ x^2 + S1^2 \ x + \ S1^3 + S3$$

thereby being capable of correcting errors of two or less in said received sequence.

2.  Apparatus according to claim 1, wherein said fourth circuit (6) for forming the value $S1^3$ is arranged to multiply $S1^2$ by S1.

3.  Apparatus according to claim 1, including a zero detecting circuit (4) which is supplied with said syndromes S1 and S3 from said first and second circuits (2,3) and which inhibits an output of said Chien search circuit (8) when both of said syndromes S1 and S3 are zero.

4.  A method of decoding a Bose-Chaudhuri-Hocquenghem (BCH) code, the method comprising the steps of:

forming syndromes S1 and S3 from a received code sequence;

processing and combining said syndromes to form the value $(S1^3 + S3)$;

using a Chien search circuit (8) to produce an output signal corresponding to

$\sigma'(x) = S1 \ x^2 + S1^2 \ x + S1^3 + S3$; and

inverting bits in said received sequence in accordance with said output signal, thereby correcting errors in said received sequence.

## Fig. 1

Fig. 2

Fig. 3

Fig. 4

# Fig. 5

# Fig. 6

# Fig. 7

# Fig. 8